# EUROPEAN PATENT APPLICATION

(11) **EP 4 306 234 A1**
(43) Date of publication of application: **17.01.2024**
(21) Application number: 22185223.9
(22) Date of filing: 15.07.2022
(51) Int. Cl.: B22F 1/068, B22F 1/103, B22F 1/12, B22F 1/142, B22F 3/10, B22F 7/00, B22F 7/04, H01L 23/00

(54) **SINTERING PASTE AND METHOD FOR PRODUCING A SINTERING PASTE**

(71) Applicant: Technische Hochschule Ingolstadt, 85049 Ingolstadt (DE)
(72) Inventor: GORDON, Elger, 85053 Ingolstadt (DE); BHOGARAJU, Sri Krishna, 85055 Ingolstadt (DE); SACCON, Rodolfo, 85057 Ingolstadt (DE)
(74) Representative: Dr. Gassner & Partner mbB

(57) **Abstract**

The invention concerns a sintering paste for forming a copper-containing interconnection layer between two solid substrates, wherein the sintering paste is obtained by
a) providing copper-containing microparticles of elementary metal, a binder, a copper formate and a complexing agent complexing the copper formate, wherein the complexing agent is an alkanolamine or a diamine, wherein the binder is a diol or a triol,
b) mixing the copper formate, the binder and the complexing agent for obtaining a mixture,
c) mixing the mixture obtained in step b) and the copper-containing microparticles for obtaining a composition,
d) heating the composition obtained in step c) to a temperature in the range from 120 °C to 180 °C and maintaining the temperature,
e) waiting until at least 75 wt.% of the complexing agent is evaporated and copper nanoparticles are formed for obtaining the sintering paste.

## Description

The present invention relates to a sintering paste for forming a copper-containing interconnection layer between two solid substrates, a method for producing a sintering paste and a use of the sintering paste.

Die-attach bonding is a key process to realize high-temperature operation of power semiconductor devices. High Pb solders have been a preferred and well established choice over the past decades. However strict regulations concerning hazardous substances restrict the usage of high Pb solders and the few exceptions that exist today are also foreseen to be banned in the near future. With the increase in the usage of wide-bandgap (WBG) semiconductor devices, it is imperative to find sustainable and reliable alternatives both on the economical and the technical fronts. Interconnect materials and technologies need to be able to fulfill the challenging requirements of the WBG semiconductor devices and at the same time need to be economical for enabling mass production.

Currently, there are two established methods to produce high-temperature bonds while benefiting from the comparatively low-temperature bonding temperature: Transient liquid phase (TLP) bonding and particle sintering. Although various studies reported successful production of an in-situ phase with a higher re-melting point, thermo-mechanical fracture behavior of TLP bonded joint appeared to have a major drawback. That is due to microstructure of the TLP bonded joint as it is made of brittle intermetallic compounds (IMCs). However, for the case of particle sintering, there are promising reports that suggest Ag-sintered joint as a candidate for high-temperature WBG applications. During sintering, it is possible to realize a connection, which consists of one metal throughout. Beside the high thermal conductivity of the material, the advantage is that the interconnect is established at relative low temperature (250 °C) but is stable at higher temperature (over 300 °C). However, sintered Ag particles have its own drawbacks: High cost and low-electromigration resistance.

Liu, X. et al. "Low temperature sintering of MOD assisted Ag paste for die-attach application", Materials Letters 305 (2021), 130799, discloses a silver sinter paste based on silver oxalate mixed with ethylamine, propylamine, ethylenediamine or 1-2-diaminopropane, respectively. The resulting ink was freeze-dried in order to obtain four concentrates. Each of the obtained concentrates was subsequently mixed with commercial silver particles and a mixture of isopropanol, ethylene glycol and terpineol and coated on a direct bonding copper substrate. After preheating the samples at 75 °C for 10 min, the bonding process was carried out at 175 °C for 15 min with 10 MPa. The sintering of the concentrates resulted in the *in situ* formation of silver nanoparticles. Here, among all the concentrates the concentrate that was obtained by mixing silver oxalate with propylamine showed the smallest *in* situ-formed nanoparticles and the highest joint strength of 42,7 MPa.

Copper is approximately 100 times cheaper than silver and also more abundant and easily available. It has a lower co-efficient of thermal expansion than silver and has nearly the same electrical and thermal conductivities. However, the higher melting point of copper means that the sintering temperatures are also slightly higher than in case of silver. Furthermore, the susceptibility to oxidize quickly under atmosphere is a major drawback when using copper as this is detrimental to the mechanical and thermal integrity of the joint.

From EP 3 778 069 A1, a copper paste comprising a dispersion medium and metal particles, including first-type particles and second-type particles, is known. The first-type particles are copper particles having an average particle diameter of 1 to 100 µm and having nanostructures on the surface thereof. The second-type particles are copper particles having an average particle diameter of 0.05 to 5 µm. The average particle diameter of the first-type particles is 2 to 550 times the average particle diameter of the second-type particles.

Bhogaraju, S. K. et al. "Copper die bonding using copper formate based pastes with alpha-terpineol, amino-2-propanol and hexylamine as binders", 2020 IEEE 8th Electronics System-Integration Technology Conference (ESTC), 2020, pp. 1-7, discloses copper pastes based on Cu(II) formate tetrahydrate mixed with either PEG600, alpha-terpineol, amino-2-propanol or hexylamine as binder. After completion of the thermal decomposition process, the formation of pure metal copper nanoparticles is observed. The average shear strength values of the sinter pastes were 30 MPa, 9 MPa, 2 MPa for the binders PEG600, alpha-terpineol and amino-2-propanol, respectively, whereas hexylamine as binder established no sufficient bond strength to perform shear tests.

Bhogaraju, S. K. et al. "Die-attach bonding for high temperature applications using thermal decomposition of copper(II) formate with polyethylene glycol", Scr. Mater. 2020, 182, 74-80, discloses copper pastes based on Cu(II) formate mixed with either PEG600, alpha-terpineol or a mixture of alpha-terpineol and polyvinyl butyral. From the tested sintering pastes, the Cu(II) formate/PEG600 paste at a weight ratio of 63/37 showed the highest shear strength value of 60 MPa. In addition, thermal decomposition of Cu(II) formate results in the *in situ* formation of copper nanoparticles.

According to Bhogaraju, S. K. et al. "Novel approach to copper sintering using surface enhanced brass micro flakes for microelectronics packaging", Journal of Alloys and Compounds, Volume 844, 2020, 156043, etched copper or brass flakes were mixed with PEG600 as binder to obtain a paste formulation. The use of PEG600 in the paste formulation enables the *in situ* reduction of Cu oxides during sintering. The reduction products are copper nanoparticles which act as nano jointers between the micro-sized flakes thereby realizing a bulk like microstructure with a shear strength value of 62 MPa in case of the etched copper flakes.

Choi, W. L. et al. "Characterization of the die-attach process via low-temperature reduction of Cu formate in air", J Mater Sci: Mater Electron 30, 2019, 9806-9813 discloses a Cu-complex sludge formed by a mixture of copper oxide and formic acid which is filtered, washed with ethanol, dried and subsequently mixed with alpha-terpineol at a weight ratio of 5.9:4.1 to give a copper paste.

Bhogaraju, S. K. et al. "Die-attach bonding with etched micro brass metal pigment flakes for high-power electronics packaging", ACS Appl. Electron. Mater. 2021, 3, 10, 4587-4603, discloses a sinter paste composed of etched microscale brass metal pigment flakes and a binder mixture of alpha-terpineol and polyethylene glycol 600 (PEG600).

EP 3 626 785 B1 discloses a metal paste comprising 65 to 85 % by weight of metal particles and 10 to 35 % by weight of organic solvent, wherein 70 to 100 % by weight of the metal particles consist of organically coated copper flakes comprising a specific surface in the range of 1.9 to 3.7 m²/g, a total oxygen content in the range of 2 to 4 % by weight, and a total carbon to total oxygen weight ratio in the range of 0.25 to 0.9.

The problem to be solved by the present invention is to provide an alternative sintering paste, an alternative method for producing the sintering paste and a use of this sintering paste. The sintering paste and the method shall enable sintering with short sintering times, with low sintering temperature and/or with low sintering pressure. Sintering of the sintering paste shall result in a homogenous bonding interface. The sintering paste shall further ensure high ductility without requiring a reducing inert gas atmosphere during sintering.

The problem is solved by the subject-matter of claims 1, 10 and 15 of the present invention. Embodiments of the invention are subject-matter of claims 2 to 9 and claims 11 to 14.

According to the invention a sintering paste for forming a copper-containing interconnection layer between two solid substrates is provided. The sintering paste is obtained by the following steps:
a) Providing copper-containing microparticles of elementary metal, a binder, a copper formate and a complexing agent complexing the copper formate, wherein the complexing agent is an alkanolamine or a diamine, wherein the binder is a diol or a triol,
b) mixing the copper formate, the binder and the complexing agent for obtaining a mixture,
c) mixing the mixture obtained in step b) and the copper-containing microparticles for obtaining a composition,
d) heating the composition obtained in step c) to a temperature in the range from 120 °C to 180 °C and maintaining the temperature,
e) waiting until at least 75 wt.%, in particular at least 80 wt.%, in particular at least 85 wt.%, in particular at least 90 wt.%, in particular at least 95 wt.%, in particular at least 99 wt.%, and maximal 100 wt.% of the complexing agent is evaporated and copper nanoparticles are formed for obtaining the sintering paste.

In the mixture according to step b), the complexing agent complexes the copper formate to form a complex. This complex may be formed by interaction of the copper cation of the copper formate with the amine groups and/or the hydroxy groups of the complexing agent, wherein the amine groups and/or the hydroxy groups of the complexing agent act as ligands. The alkanolamine may be an unbranched alkanolamine having a carbon chain length of at most six carbon atoms, in particular of at most five carbon atoms, in particular of at most four carbon atoms, in particular methanolamine, ethanolamine or amino-2-propanol, or 2-amino-2-methylpro-pan-1-ol. The diamine may be ethylenediamine, 1,2-diaminopropane or 1,3-diaminopropane. If the complexing agent has a total of two ligands, such as amino-2-propanol, 2-amino-2-methylpropan-1-ol, ethylenediamine, 1,2-diaminopropane or 1,3-diaminopropane, the complexing agent may be capable of binding the copper atom of the copper formate through two sites, namely the amine group(s) and/or the hydroxy group, so that a chelating effect may be achieved. A complexing agent that binds through two sites is classified as bidentate and the corresponding complexes tend to be relatively stable compared to complexes derived from monodentate complexing agents, in particular monoamines and alcohols, that bind through one site. The relatively high stability, called chelate effect, also affects physicochemical parameters, e.g. the boiling temperature and the decomposition temperature of the formed complex.

The inventors of the present invention found that the complex formed by the complexing agent and the copper formate results in the *in situ* formation of copper nanoparticles. The *in situ* formation of copper nanoparticles is achieved by heating of the complex to the temperature in the range from 120 °C to 180 °C, wherein the complexed copper formate decomposes and the copper nanoparticles are formed. Depending on the duration of the waiting at step e) an arithmetic average particle diameter of at least 100 nm, in particular at least 150 nm, in particular at least 200 nm, in particular at least 250 nm, in particular at least 300 nm, in particular at least 350 nm, in particular at least 400 nm, in particular at least 450 nm, and at most 1000 nm, in particular at most 950 nm, in particular at most 900 nm, in particular at most 850 nm, in particular at most 800 nm, in particular at most 750 nm, in particular at most 700 nm, in particular at most 650 nm, in particular at most 600 nm, in particular at most 550 nm, in particular at most 500 nm, is obtained.

The inventors further found that the size of the copper nanoparticles formed *in situ* is further dependent on the alkanolamine forming a complex with the copper formate. The *in situ* formed copper nanoparticles, in particular the copper nanoparticles having an arithmetic average particle diameter of at least 100 nm and at most 500 nm, allow improved filling of the recesses of the copper-containing microparticles, resulting in improved packaging and densification. This also results in a relatively high arithmetic average shear strength value obtainable with the sintering paste according to the invention after sintering, in particular in an arithmetic average shear strength value in the range of 80 MPa to 95 MPa. In addition, relatively small nanoparticles, in particular nanoparticles having an arithmetic average particle diameter of at least 100 nm and at most 250 nm, in particular of at least 150 nm and at most 200 nm, have a relatively high surface energy. The relatively high surface energy of the relatively small nanoparticles enables sintering of the nanoparticles within a relatively short sintering time at a relatively low sintering temperature.

The inventors of the present invention further found that the copper nanoparticles formed do not oxidize during the waiting according to step e). The inventors found that the binder in the composition provides a reducing effect on the copper nanoparticles formed, thus preventing oxidation of the formed copper nanoparticles. Thus, a further agent in the sintering paste according to the invention or a protecting atmosphere for preventing oxidation of the formed copper nanoparticles does not have to be provided.

Furthermore, the copper nanoparticles formed do not agglomerate during the waiting according to step e). The inventors of the present invention found that the copper nanoparticles formed are dispersed uniformly between the copper-containing microparticles of elementary metal, in particular if the copper-containing microparticles are provided as flakes, in particular flakes having an arithmetic average particle diameter of at most 5 µm. Thus, a further agent for preventing agglomeration of the formed copper nanoparticles does not have to be provided in the sintering paste according to the invention.

The copper-containing microparticles, in particular the flakes, stack in a uniform stacking pattern, in particular by horizontally stacking over each other. Thus, a relatively large surface contact between these copper-containing microparticles is provided. The relatively large surface contact between the copper-containing microparticles allows sintering within a relatively short sintering time, at a relatively low sintering pressure and/or at a relatively low sintering temperature. The inventors of the present invention found that the relatively short sintering time, the relatively low sintering pressure and the relatively low sintering temperature can be further decreased if nanoconnections are provided between the stacked copper-containing microparticles, in particular between the flakes. In the sintering paste according to the invention these nanoconnections may be provided by the copper nanoparticles formed *in situ* during the waiting according to step e). The copper nanoparticles formed *in situ* may be uniformly distributed between the copper-containing microparticles, in particular between the flakes, and thereby may provide the nanoconnections between these copper-containing microparticles without affecting the uniform stacking pattern of these copper-containing microparticles. Furthermore, the copper-containing microparticles, in particular the flakes, and the copper nanoparticles show a relatively high surface energy difference. The copper nanoparticles show a relatively high surface energy. The copper-containing microparticles, in particular the flakes, show a relatively low surface energy. The surface energy can be defined as the excess energy at the surface of a material compared to the bulk of the material. The inventors of the present invention found that a relatively high surface energy difference between said copper containing microparticles and the copper nanoparticles results in a relatively fast diffusion of atoms from the copper nanoparticles having a relatively high surface energy to the copper containing microparticles, in particular the flakes, having a relatively low surface energy. Thus, by the relatively fast diffusion of atoms, the formation of sintering necks is promoted. Therefore, the relatively high surface energy difference between said copper containing microparticles and the copper nanoparticles further promotes the sintering of the sintering paste within a relatively short sintering time at a relatively low sintering pressure and a at a relatively low sintering temperature.

The elementary metal of the copper-containing microparticles may be copper or a copper alloy. In particular, the copper alloy may be bronze or brass. The copper alloy microparticles show good thermal conductivity in the composition according to step c), which can be further increased if the composition according step c) comprises elemental copper microparticles.

The copper-containing microparticles may be provided as flakes. In particular, the flakes may have an arithmetic average particle diameter of at most 25 µm, in particular an arithmetic average particle diameter of at most 20 µm, in particular an arithmetic average particle diameter of at most 15 µm, in particular an arithmetic average particle diameter of at most 10 µm, in particular an arithmetic average particle diameter of at most 5 µm, in particular an arithmetic average particle diameter of at most 4 µm, in particular an arithmetic average particle diameter of at most 3 µm. The flakes may be obtained by grinding in a ball mill and have a lamellar or irregular shape. The inventors of the present invention found that the lamellar or irregular shape of the flakes, in particular of the flakes with an arithmetic average particle diameter of at most 5 µm, in particular an arithmetic average particle diameter of at most 4 µm, in particular an arithmetic average particle diameter of at most 3 µm, show better contact surfaces compared to spherical microparticles. The lamellar or irregular shape also results in a larger surface area of the flakes, which leads to improved densification and coarsening. This promotes the formation of sinter necks and material transport.

The commercially available copper-containing microparticles, in particular the flakes, may comprise stearic acid, in particular stearic acid coated on the surface of these microparticles. Stearic acid on the surface of these microparticles prevents an agglomeration and cold welding of the copper-containing microparticles. However, due to the boiling point of 361 °C, this stearic acid on the surface of the microparticles does not evaporate during the sintering, thus resulting in a reduced sintering of the copper-containing microparticles. The inventors found that commercially available copper-containing microparticles, in particular the flakes, may be chosen such that they comprise a relatively low total weight of stearic acid in relation to the total weight of the microparticles. The total weight of stearic acid in relation to the total weight of these copper-containing microparticles may be at most 1 wt.%, in particular at most 0.5 wt.%, in particular at most 0.25 wt.%, in particular at most 0.1 wt.% and at least 0.001 wt.%, in particular at least 0.01 wt.%. The inventors of the present invention further found that such a relatively low total weight of stearic acid in relation to the total weight of these copper-containing microparticles is sufficient for preventing agglomeration and cold welding of the copper-containing microparticles without reducing sintering of these microparticles in a relevant extent.

The commercially available copper-containing microparticles, in particular the flakes, may comprise oxygen. The inventors found that commercially available copper-containing microparticles, in particular the flakes, may be chosen such that the total weight of oxygen in relation to the total weight of these copper-containing microparticles is in a range of 1 wt.% to 7 wt.%, in particular in a range of 2 wt.% to 6 wt.%, in particular in a range of 3 wt.% to 5 wt.%, in particular in a range of 3.1 wt.% to 4.9 wt.%. The inventors of the present invention further found that generally a relatively low total weight of oxygen in relation to the total weight of said copper-containing microparticles reduces the oxidation of copper to copper oxide. By reducing the oxidation of copper to copper oxide, the formation of a copper oxide layer acting as a barrier of atom diffusion may be reduced. In the sintering paste according to the invention, the oxidation of copper to copper oxide is further reduced during the heating according to step d) and during the waiting according to step e). The inventors found that the binder in the composition provides a reducing effect on the copper-containing microparticles, thus preventing oxidation of the copper-containing microparticles if they are chosen such that the total weight of oxygen in relation to the total weight of these microparticles is in the above given range. In the sintering paste according to the invention, also a relatively high total weight of oxygen in relation to the total weight of said copper-containing microparticles results in a reduced oxidation of copper to copper oxide.

Copper flakes and copper-alloy based flakes can be purchased as metal powders Cubrotec, Rogal^{®} Bronze GS and Rogal^{®} Brass GS, which are offered by the company Schlenk Metallic Pigments GmbH, Germany.

The copper-containing microparticles may have superficial recesses. The superficial recesses of the copper-containing microparticles may be formed by means of etching with an acid. In particular, the acid may be hydrochloric acid or formic acid. Etching refers to the wet chemical activation of the surface of the copper-containing microparticles or copper-containing flakes resulting in surface modification to a rough surface texture. Etching of copper-containing microparticles through selective etching results in high energy free surfaces. The increased surface area leads to a higher specific surface energy *γ* (J/m²) distributed over the total surface area A (m²) and therefore to a reduction of the total surface energy which is the driving force for sintering. In comparison to copper-based sintering pastes, a sintering paste composed of surface-modified etched copper-alloy particles results in a higher arithmetic average shear strength value. In the case of microparticles consisting of a copper alloy, etching can also lead to selective dealloying of the alloying element. For instance, in brass microparticles, the alloying element zinc is selectively etched. Nevertheless, a residual amount of the alloying element always remains in the microparticles after etching, regardless of the original content of the alloying element. In particular, hydrochloric acid enables selective etching of zinc out of the brass flakes without forming any unwanted residues, in particular without forming residues containing a metal chloride and/or a metal oxide. With hydrochloric acid, the etching byproducts may be ZnCl₂ and CuCl₂, which are both highly soluble in water. Another etching byproduct may be CuCI which is highly soluble in concentrated hydrochloric acid. Further byproducts may be water and H₂. Etching with formic acid may lead to the formation of zinc formate and copper formate. Zinc formate and copper formate are both soluble in water.

A maximal superficial extension of any of the superficial recesses of the microparticles may be 1 µm, in particular 900 nm, in particular 800 nm, in particular 700 nm, in particular 600 nm, in particular 500 nm, in particular 400 nm, in particular 300 nm, in particular 200 nm, in particular 100 nm. A minimal superficial extension of any of the superficial recesses of the microparticles may be 1 nm, in particular 5 nm, in particular 10 nm. The recesses ensure a relatively large surface area of the microparticles. A relatively large surface area of the microparticles results in a relatively low total surface energy. A relatively low total surface energy of the microparticles enables a relatively high rate of sinter neck formation between the microparticles during sintering.

The copper formate may be an anhydrous copper formate, in particular Cu(HCOO)₂, or a hydrate of copper formate, in particular a copper formate tetrahydrate (Cu(HCOO)₂*4H₂O). The copper formate is considered to be anhydrous not only if it contains no water, but also if it contains only traces of water, in particular a water content of at most 5 wt.%, in particular at most 1 wt.%, in particular at most 0.5 wt.%, in particular at most 0.1 wt.%, in particular at most 0.05 wt.%, in particular at most 0.01 wt.%, in particular at most 0.005 wt.%, in particular at most 0.001 wt.%. Anhydrous copper formate can be obtained by drying it, e. g. at a temperature in the range from 85 °C to 110 °C, in particular at a temperature of 100 °C.

The diol forming the binder may be a diol having an arithmetic average molar mass of at least 60 g/mol and at most 100 g/mol, in particular ethylene glycol, diethylene glycol, propylene glycol or butylene glycol. The triol forming the binder may be a triol having an arithmetic average molar mass of at least 75 g/mol and at most 100 g/mol, in particular glycerol. During the decomposition of the diol or the triol, a reducing atmosphere is created which prevents the oxidation of the copper to copper oxide without the requirement of providing an additional protective gas atmosphere to be applied from the outside. Therefore, the diol or the triol in the sintering paste according to the invention enables the *in situ* reduction of Cu oxides during the sintering process with little effort. In contrast to polymeric glycols, in particular polymeric ethyl glycol, in particular polymeric ethyl glycol having an arithmetic average molar mass of more than 100 g/mol, the evaporation of the diol, in particular the diol having an arithmetic average molar mass of at least 60 g/mol and at most 100 g/mol, is achieved at a relatively low temperature, in particular at a temperature of at most 200 °C. For example, the evaporation of ethylene glycol is achieved at a temperature of 197 °C. In order to evaporate the polymeric ethyl glycol, a relatively high temperature of at least 200 °C is necessary. However, evaporation of the binder at a relatively high temperature might result in undesirable gas bubbles formed during sintering, which can weaken the bond. With a mixture of ethylene glycol and alpha-terpineol, it is also possible to achieve the combined effect of producing fewer gas bubbles during heating, while at the same time making use of the reducing atmosphere.

The total weight of the microparticles may be at most 65 wt.%, in particular at most 60 wt.%, in particular at most 55 wt.%, in particular at most 50 wt.%, in particular at most 45 wt.%, in particular at most 40 wt.%, in particular at most 35 wt.%, of the total weight of the composition as specified in step c). The total weight of the binder may be at most 40 wt.%, in particular at most 35 wt.%, in particular at most 30 wt.%, in particular at most 25 wt.%, in particular at most 20 wt.%, of the total weight of the composition as specified in step c). The remaining part of the composition as specified in step c) may be formed by the copper formate and the complexing agent. The stoichiometric ratio between the copper formate and the complexing agent in the composition as specified in step c) may depend on the number of ligands of the complexing agent. If the complexing agent has a total of two ligands, in particular one hydroxy group and one amine group, e.g. amino-2-propanol or 2-amino-2-methyl-propan-1-ol, the complexing agent and copper formate may be present in a stochiometric ratio of 1:1, in particular in a stochiometric ratio of 2:1, in the composition as specified in step c). However, if the complexing agent has only one ligand, in particular one hydroxy group or one amine group, e.g. hexylamine, the complexing agent and the copper formate may be present in a stoichiometric ratio of 2:1.

The total content of solids in the sintering paste according to the invention may be at most 70 wt.%, in particular at most 65 wt.%, in particular at most 60 wt.%. The inventors found that despite the relatively low total content of solids and the resulting relative low viscosity compared to silver sintering pastes having a total content of solids of about 90 wt.%, the sintering paste according to the invention, in particular a sintering paste having a total content of solids of at most 65 wt.%, results in relatively high shear strength value, in particular an arithmetic average shear strength value in the range from 100 MPa to 40 MPa of the sintered joints after sintering of the sintering paste according to the invention. The low viscosity of the sintering paste according to the invention enables its easy processability and a good and its even spreadability on a surface.

The inventors further found that a composition as specified in step c) comprising or consisting of in particular brass flake microparticles having superficial recesses formed by means of etching, copper formate, amino-2-propanol as complexing agent complexing the copper formate and ethylene glycol as binder, results in a relatively high shear strength value of 100 MPa of the sintered joints after sintering, in particular if the total content of solids is at most 65 wt.%.

The invention also concerns a method for producing the sintering paste according to the invention comprising the steps of
a) providing the copper-containing microparticles of elementary metal, the copper formate, the complexing agent complexing the copper formate and the binder as specified above,
b) mixing the copper formate, the binder and the complexing agent for obtaining a mixture,
c) mixing the mixture obtained in step b) and the copper-containing microparticles to obtain a composition,
d) heating the composition obtained in step c) to a temperature in the range from 120 °C to 180 °C, in particular a temperature in the range from 130 °C to 170 °C, in particular a temperature in the range from 140 °C to 160 °C, and maintaining the temperature, wherein the temperature may be maintained for at least 5 minutes, in particular at least 10 minutes, in particular at least 15 minutes, and for at most 30 minutes, in particular at most 25 minutes, in particular at most 20 minutes,
e) waiting until at least 75 wt.%, in particular at least 80 wt.%, in particular at least 85 wt.%, in particular at least 90 wt.%, in particular at least 95 wt.%, in particular at least 99 wt.%, and maximal 100 wt.% of the complexing agent is evaporated and copper nanoparticles are formed for obtaining the sintering paste.

The method may further comprise a step f) of cooling of the sintering paste obtained in step e) to a further temperature in the range from 15 °C to 40 °C, in particular 20 °C to 30 °C. Cooling may be performed by active cooling but usually is passive cooling, i. e. by letting the sintering paste cool down to the further temperature which usually is ambient temperature.

Before providing the copper formate according to step a), the copper formate, in particular copper formate tetrahydrate, may be heated to a copper formate drying temperature in the range from 85 °C to 110 °C, in particular in the range from 90 °C to 105 °C, in particular in the range from 95 °C to 100 °C. The copper formate drying temperature may be maintained for at least 10 minutes, in particular at least 20 minutes, in particular at least 30 minutes, and at most 3 hours, in particular at most 2 hours, in particular at most 1 hour. Subsequently, the copper formate may be crushed, in particular manually. The steps of copper formate heating to the copper formate drying temperature, maintaining the copper formate drying temperature and crushing the copper formate may be performed in an atmosphere containing oxygen and may be repeated at least two times, in particular at least three times, in particular at least four times, and at most six times, in particular at most five times. The atmosphere containing oxygen may be provided by means of a gas mixture containing oxygen and nitrogen, such as air. Drying of the copper formate, in particular the copper formate tetrahydrate, results in the evaporation of the water complexed in the copper formate, in particular the water complexed in the copper formate tetrahydrate. By evaporation of the water complexed in the copper formate, in particular by evaporation of the water complexed in the copper formate tetrahydrate, anhydrous copper formate can be provided. The inventors found that providing anhydrous copper formate in the method for producing the sintering paste according to the invention results in relatively weak bubble formation during sintering of this sintering paste.

Mixing of the copper formate, in particular the anhydrous copper formate, and the binder in the form of the diol, in particular the ethylene glycol, or the triol results in a mixture in which the copper formate, in particular the anhydrous copper formate, is not dissolved. Only mixing the copper formate and the binder with the complexing agent complexing the copper formate, wherein the complexing agent is in particular the alkanolamine, in particular amino-2-propanol, results in a solution, in particular a solution with the binder as solvent and the complexed copper formate as solute. In this solution a complex, in particular a bidentate complex, of the copper formate and the complexing agent is formed. The following equation exemplarily shows the formation of the bidentate complex of copper formate and amino-2-propanol:

*Cu*(*HCOO*)₂ + *CH*₃*CH*₂*OHCH*₂*NH*₂ → *Cu*(*HCOO*)₂ * *CH*₃*CH*₂*OHCH*₂*NH*₂

The inventors of the present invention found that the copper formate complexed by the complexing agent, in particular the bidentate complex, is soluble in the binder. The mixture obtained in step b) comprises complexed copper formate solved in the binder. The mixing according to step b) may be performed as follows: Firstly, the copper formate and the binder may be mixed. Secondly, the mixture of the copper formate and the binder may be mixed with the complexing agent. By doing so, a relatively good solubility of the copper formate complexed by the complexing agent, in particular the bidentate complex, in the binder is enabled. The inventors of the present invention found that by firstly mixing the copper formate and the complexing agent before mixing the copper formate with the binder, the copper formate complexed by the complexing agent, in particular the bidentate complex, forms agglomerates of copper formate complexes. These agglomerates are relatively hard to solubilize in the binder.

In the method according to the invention steps a) to f), in particular at least steps a) to e), in particular at least steps b) to e), in particular at least steps c) to e), in particular at least steps d) and e), may be performed in a reducing atmosphere. The reducing atmosphere may be provided by means of a mixture of evaporated formic acid and nitrogen gas or by means of a gas mixture of hydrogen and an inert gas. The gas mixture of hydrogen and the inert gas may be a gas mixture of nitrogen and hydrogen or a gas mixture of argon and hydrogen.

The heating according to step d), the maintaining according to step d) and/or the waiting according to step e) may be performed at atmospheric pressure or at a pressure reduced vis-à-vis atmospheric pressure. The pressure reduced vis-à-vis atmospheric pressure may be a pressure in the range of 0.01 bar to atmospheric pressure, in particular in the range of 0.02 bar to 0.9 bar, in particular in the range of 0.03 bar to 0.7 bar, in particular in the range of 0.03 bar to 0.5 bar, in particular in the range of 0.03 bar to 0.3 bar, in particular in the range of 0.03 bar to 0.1 bar. The inventors of the present invention found that performing the heating according to step d), the maintaining according to step d) and/or the waiting according to step e) at the pressure reduced vis-à-vis atmospheric pressure enables the evaporation of the alkanolamine having a carbon chain length of at most six carbon atoms, in particular of at most five carbon atoms, at the temperature in the range from 120 °C to 180 °C.

Heating the composition obtained in step c) to the temperature and maintaining the temperature according to steps d) and e) results in the decomposition of the complexed copper formate, the evaporation of the complexing agent, and the *in situ* formation of copper nanoparticles. In the following reaction equation, the *in situ* formation of copper nanoparticles by thermal decomposition of the bidentate complex of copper formate and amino-2-propanol is exemplarily shown:

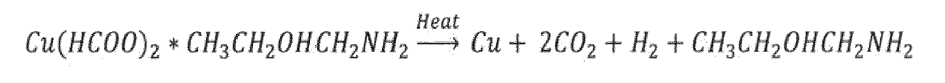

According to the above reaction equation, the copper formate complexed with amino-2-propanol decomposes during heating. The copper atom having the oxidation state +2 in the copper formate is reduced to a copper atom having the oxidation state 0. The formate in the copper formate is oxidized to hydrogen and carbon dioxide which are both evaporated due to their gaseous state. Furthermore, the bond between the amine group of the amino-2-propanol and the copper atom and the bond between the hydroxy group of the amino-2-propanol and the copper atom are broken resulting in the evaporation of the amino-2-propanol during heating.

The inventors of the present invention found that the size of the formed copper nanoparticles is dependent on the chain length of the complexing agent and the boiling point of the complexing agent. The inventors of the present invention further found that complexation of copper formate by a long-chain complexing agent, in particular a long-chain alkanolamine, which has a higher boiling point compared to a short-chain complexing agent, in particular a short-chain alkanolamine, results in the formation of smaller nanoparticles. The copper nanoparticles formed according to the method according to the invention have an arithmetic average particle diameter of at least 100 nm, in particular at least 200 nm, in particular at least 300 nm, in particular at least 400 nm, and at most 1000 nm, in particular at most 900 nm, in particular at most 800 nm, in particular at most 700 nm. The *in situ* formed copper nanoparticles, in particular the copper nanoparticles having an arithmetic average particle diameter of at least 100 nm and at most 500 nm, allow improved filling of the recesses of the copper-containing microparticles, resulting in improved packaging and densification. This also results in increased shear strength values of the sintered joints.

The inventors of the present invention further found that the complex, in particular the bidentate complex, of copper formate and the complexing agent results in a relatively low thermal decomposition temperature of the complexed copper formate compared to non-complexed copper formate. Therefore, *in situ* formation of nanoparticles of the complexed copper formate can take place at a relatively low temperature. The thermal decomposition temperature of a copper formate complexed with an alkanolamine, in particular amino-2-propanol, is 160 °C. In contrast to complexed copper formate, the thermal decomposition temperature of non-complexed copper formate is 225 °C. The relatively low thermal decomposition temperature of complexed copper formate allows the formation of copper nanoparticles at a relatively low thermal decomposition temperature, in particular at a thermal decomposition temperature in the range from 120 °C to 180 °C. Thus, by formation of copper nanoparticles at a relatively low thermal decomposition temperature, the sintering paste according to the invention can be obtained. If the copper formate is non-complexed copper formate with a thermal decomposition temperature of 225 °C, the formation of copper nanoparticles is achieved at a relatively high thermal decomposition temperature. However, by heating the non-complexed copper formate to 225 °C for the formation of copper nanoparticles, other components of the composition, in particular the binder, in particular the diol or the triol, may completely evaporate, thus resulting in a relatively solid composition without a paste-like consistency. Thus, the lack of a paste-like consistency results in lack of printability. Thus, the sintering paste according to the invention cannot be obtained with non-complexed copper formate having a relatively high thermal decomposition temperature.

The inventors of the present invention found that during steps d) and e) according to the invention, the sintering paste according to the invention remains viscous. Viscosity may be at most 300 000 mPas, in particular at most 250 000 mPas. This is particularly surprising since at least 75 wt.%, in particular at least 80 wt.%, in particular at least 85 wt.%, in particular at least 90 wt.%, in particular at least 95 wt.%, in particular at least 99 wt.%, of the complexing agent is evaporated in step e). The inventors further found that the relatively low content of solids, in particular a content of solids of at most 65 wt.%, and the binder, in particular the diol, in particular the diol having an arithmetic average molar mass of at least 60 g/mol and at most 100 g/mol, in particular ethylene glycol, ensure the relatively low viscosity of the sintering paste according to the invention during steps d) and e). The relatively low viscosity of the sintering paste according to the invention ensures a paste-like consistency and a relatively good printability of the sintering paste according to the invention. The viscosity of the sintering paste according to the invention may be measured using a standard viscosimeter, in particular a standard classical rotational viscosimeter, in particular the Thermo Scientific^{™} HAAKE^{™} Viscotester^{™} C. These rotational viscometers measure the resistance of the sintering paste according to the invention against a preset speed. The resulting torque or resistance is a measure for the viscosity of the sintering paste. The higher the torque, the higher the viscosity.

The sintering paste produced by the method according to the invention allows a relatively easy storage after production due to its paste-like consistency. In addition, storage of the sintering paste can take place over a relatively long period of time. Since the *in situ* formation of the nanoparticles takes place during the production of the sintering paste, the paste according to the invention ensures a relatively low contamination by ensuring a relatively low sublimation of the copper during sintering.

After the method according to the invention, in particular after step e), or, optionally, after step f), the sintering paste produced by the method according to the invention may be applied in a method for forming a copper-containing interconnection layer between two solid substrates comprising the steps of
g) providing the sintering paste produced by the method according to the invention, providing a first substrate and providing a second substrate,
h) applying the sintering paste according to the invention to the first substrate,
i) placing the second substrate on the sintering paste,
j) applying a bonding pressure to press the first substrate and the second substrate against one another, wherein the bonding pressure may be at least 1 MPa, in particular at least 2.5 MPa, in particular at least 5 MPa, in particular at least 7.5 MPa, in particular at least 10 MPa, and at most 40 MPa, in particular at most 35 MPa, in particular at most 30 MPa, in particular at most 25 MPa, in particular at most 20 MPa, in particular at most 15 MPa,
k) heating the sintering paste to a sintering temperature and maintaining the sintering temperature and the bonding pressure, wherein the sintering temperature is a temperature in the range from 200 °C to 295 °C, in particular a temperature in the range from 205 °C to 275 °C, in particular a temperature in the range from 210 °C to 270 °C, in particular a temperature in the range from 215 °C to 265 °C, in particular a temperature in the range from 220 °C to 260 °C, in particular a temperature in the range from 225 °C to 255 °C, in particular a temperature in the range from 230 °C to 250 °C, in particular a temperature in the range from 235 °C to 245 °C, wherein the sintering temperature is optionally maintained for at least 1 minute, in particular at least 2 minutes, in particular at least 3 minutes and for at most 6 minutes, in particular at most 5 minutes, in particular at most 4 minutes, wherein the bonding pressure is optionally maintained for at least 3 minutes, in particular at least 4 minutes, in particular at least 5 minutes, and for at most 8 minutes, in particular at most 7 minutes, in particular at most 6 minutes,
I) waiting until at least 90 wt.% of the binder is evaporated, in particular until at least 95 wt.% of the binder is evaporated, in particular until at least 99 wt.% of the binder is evaporated, and an interconnection between the two solid substrates is formed,
m) cooling the first substrate, the sintered sintering paste and the second substrate at least to a cooling temperature, wherein the cooling temperature is a temperature in the range from 15 °C to 40 °C, in particular 20 °C to 30 °C.

Applying the sintering paste according to the invention to the first substrate may be performed by stencil printing, by screen printing or by cartridge dispensing.

After applying the sintering paste according to the invention to the first substrate and before applying the bonding pressure to press the first substrate and the second substrate against one another, the sintering paste according to the invention may be heated to a pre-drying temperature in the range from 100 °C to 160 °C, in particular in the range from 105 °C to 155 °C, in particular in the range from 110 °C to 150 °C, in particular in the range from 115 °C to 145 °C, in particular in the range from 120 °C to 140 °C, in particular in the range from 125 °C to 135 °C. The pre-drying temperature may be maintained for at least 30 seconds, in particular at least 1 minute, in particular at least 2 minutes, in particular at least 3 minutes and for at most 6 minutes, in particular at most 5 minutes, in particular at most 4 minutes. Heating the sintering paste according to the invention to the pre-drying temperature and maintaining the pre-drying temperature may be performed in a reducing atmosphere or in an atmosphere containing oxygen. Heating the sintering paste according to the invention to the pre-drying temperature and maintaining the pre-drying temperature may be performed after step h) and before step i). The inventors of the present invention found that *in situ* nanoparticle formation prior to pre-drying results in a reduced standard deviation of an arithmetic average shear strength value determined from shear strength values of several sintered joints generated with the same sintering paste.

Cooling according to step m) may be performed by active cooling but usually is passive cooling, i. e. by letting the sintering paste cool down to the fourth temperature which usually is ambient temperature.

At least steps k) and I), in particular at least steps k) to m), in particular at least steps j) to m), in particular at least steps i) to m), in particular at least steps h) to m), in particular steps g) to m), of the method for forming the copper-containing interconnection layer between two solid substrates may be performed in a reducing atmosphere. The reducing atmosphere may be provided by means of a mixture of evaporated formic acid and nitrogen gas or by means of a gas mixture of hydrogen and an inert gas. The gas mixture of hydrogen and the inert gas may be a gas mixture of nitrogen and hydrogen or a gas mixture of argon and hydrogen. The inventors of the present invention found that sintering in a reducing atmosphere, in particular sintering by means of a mixture of evaporated formic acid and nitrogen gas, results in relatively high shear strength values of the resulting copper bond.

The inventors of the present invention found that at least steps k) and I), in particular at least steps k) to m), in particular at least steps j) to m), in particular at least steps i) to m), in particular at least steps h) to m), in particular steps g) to m), of the method for forming the copper-containing interconnection layer between two solid substrates may be performed in an atmosphere containing oxygen. The atmosphere containing oxygen in the method according to the invention may be provided by means of a gas mixture containing oxygen and nitrogen. The gas mixture containing oxygen and nitrogen may be air. The inventors of the present invention found that the sintering paste produced by the method according to the invention provides a relatively good conductivity of the copper bond after sintering due to relatively low oxide impurities. The oxide impurities are so low that it is not necessary to apply a reducing atmosphere during sintering.

Sintering of the sintering paste produced by the method according to the invention ensures relatively high shear strength values of the resulting bonds. Despite the relatively low content of solids, the shear strength values are similar to the shear strength values achievable with commercial silver sintering pastes with a content of solids of about 90 wt.%. Due to the relatively low content of solids and since silver is relatively expensive compared to copper, material costs can be saved by using the sintering paste according to the invention. In addition, the sintering paste according to the invention enables a relatively energy-efficient production of a copper bond, since the *in situ* formation of nanoparticles was already realized during the production of the sintering paste. Despite these differences to commercial silver sintering pastes, the sintering process of the sintering paste according to the invention is compatible with industrialized silver sintering lines. Thus, a simple exchange of the commercial silver sintering pastes with the copper sintering paste according to the invention is possible.

The inventors of the present invention further found that the *in situ* formation of nanoparticles during sintering, in particular during sintering of a sintering paste with a relatively high water content, results in a relatively high volume shrinkage and degassing of the organic components. This can result in relatively high surface irregularities and a relatively high inhomogeneity of the resulting copper containing bond and thus result in a relatively high surface roughness of the copper containing bond. Surface roughness may be measured by atomic force microscopy, by optical microscopy, in particular by three-dimensional optical microscopy, or by profilometry, in particular by three-dimensional profilometry.

By forming nanoparticles *in situ* at a relatively low temperature before pre-drying and/or before sintering when producing the sintering paste according to the invention and in particular a sintering paste containing anhydrous copper formate, relatively high surface irregularity and relatively high inhomogeneity of a copper containing bond produced by means of such a sintering paste can be avoided. Therefore, the sintering paste according to the invention enables a relatively good surface control by ensuring a relatively low surface roughness. The relatively low surface roughness and relatively good surface control of the sintering paste according to the invention is enabled by a relatively low total weight of water in relation to the total weight of the sintering paste according to the invention. The total weight of water in relation to the total weight of the sintering paste according to the invention may be at most 5 wt.%, in particular at most 4 wt.%, in particular at most 3 wt.%, in particular at most 2 wt.%, in particular at most 1 wt.%, in particular at most 0.5 wt.%, in particular at most 0.1 wt.%, in particular at most 0.05 wt.%, in particular at most 0.01 wt.%, in particular at most 0.005 wt.%, in particular at most 0.001 wt.%.

The first substrate may be made of or consist of a metal or a metal oxide and the second substrate may be made of or consist of the metal, a further metal, the metal oxide, a further metal oxide or a surface mount device component. The metal or the further metal may be gold, silver, nickel, copper, pre-treated copper or tin. The metal oxide or the further metal oxide may be aluminum oxide. The surface mount device component may be a capacitor, a chip resistor, a crystal oscillator, a diode, a fuse, an inductor, an integrated circuit, an LED, a network resistor, a transformer or a transistor. The inventors of the present invention found that the binder can also reduce oxides on the first and/or the second substrate. Therefore, the sintering paste produced by the method according to the invention enables sintering on copper, silver and/or nickel substrates even if these substrates are covered by an oxide layer.

The pre-treated copper may be pre-treated for example by coating a copper substrate with an organic surface protection (OSP) layer, wherein the OSP layer protects the copper against oxidation and is dissolved during the soldering process. Alternatively, other methods, e.g. sol-gel application or CVD, can be used to coat the copper substrate with a protective layer in order to protect the copper against oxidation.

The invention further concerns the use of the sintering paste according to the invention for forming a copper-containing interconnection layer between two solid substrates, in particular in microelectronics packaging, in electric vehicle technologies, in hybrid electric vehicle technologies, in high power electronics packaging, and/or in thick film technology. The invention further concerns the use of the sintering paste according to the invention for die-attach bonding. The invention further concerns the use of the sintering paste according to the invention for forming a conductive path on a solid substrate. The microelectronics packaging may be WBG semiconductor packaging. The high power electronics packaging may be high power light emitting diode packaging. The inventors of the present invention found that the use of the sintering paste according to the invention for forming a copper-containing interconnection layer between two solid substrates or for forming a conductive path on a solid substrate enables a relatively low thermal load of the solid substrate(s) and any electronic component, in particular the surface mount device component as specified above, on the substrate(s) when forming the interconnection layer or conductive path. This is due to the relatively low sintering temperature required to sinter the sintering paste according to the invention.

If the sintering paste according to the invention is used for forming a conductive path on a solid substrate, the solid substrate may be any substrate defined above as first or second substrate as far as it is not an electrically conductive first or second substrate.

All features indicated in the specification are to be understood as features applicable to all embodiments of the invention. This means, for example, that a feature indicated for the sintering paste according to the invention can also be applied to the method for producing the sintering paste according to the invention, the method for forming a copper-containing interconnection layer between two solid substrates, and/or the use according to the invention, and vice versa. Furthermore, as far as not specified the term "average" always means "arithmetic average". As far as not specified the term "diameter" always means "Volume Equivalent Spherical Diameter" (=VESD). The particle size for determining that diameter can be determined by static light scattering, laser diffraction, microscopy, in particular optical microscopy, followed by image analysis, sedimentation analysis and by use of a disc centrifuge. The abbreviation "wt.%" means "percent by weight".

The invention will be explained in more detail with reference to the following embodiments.

### Example 1: Compositions

The following compositions were tested:

**Table 1: Paste compositions**

| **SI.No** | **Paste composition** | | | **Paste composition (wt.-%)** | | | **Total content of solids in paste (wt.-%)** |
|---|---|---|---|---|---|---|---|
| **-** | **Copper-containing microparticles** | **Binder** | **Copper formate and complexing agent** | **Copper-containing mi-croparti-cles** | **Binder** | **Copper formate: Complexing agent** | |
| 1 | Copper flakes | Octanol | - | 75 | 25 | - | 75 |
| 2 | Copper flakes | Butanol | - | 75 | 25 | - | 75 |
| 3 | Copper flakes | Ethylene glycol | - | 63 | 37 | - | 63 |
| 4 | Etched brass flakes | Ethylene glycol | - | 57 | 43 | - | 57 |
| 5 | Etched brass flakes | Polyehtylene glycol 600 | - | 63 | 37 | - | 63 |
| 6 | Etched brass flakes | alpha-terpineol + Polyethylene glycol 600 | - | 65 | 35 | - | 65 |
| 7 | Copper flakes | alpha-terpineol + Polyethylene glycol 600 | - | 78 | 22 | - | 78 |
| 8-13 | Copper flakes | Ethylene glycol | Copper formate + Amino-2-propanol | 64 | 12 | 12:12 | 68 |
| 14-20 | Etched brass flakes | Ethylene glycol | Copper formate + Amino-2-propanol | 60 | 13 | 13:13 | 64 |

Table 1 shows different sintering pastes and their respective compositions. As can be seen in Table 1, the sintering pastes from compositions No. 1 to No. 7 do not contain copper formate and do not contain a complexing agent. The sintering pastes from compositions No. 8 to No. 13 refer to sintering pastes of identical composition, each prepared and tested in trials independent from each other. The same applies to the sintering pastes from compositions No. 14 to No. 20.

In each of the sintering pastes from compositions No. 8 to No. 13, the total weight of the copper flakes in relation to the total weight of the composition is 64 wt.%, the total weight of the ethylene glycol in relation to the total weight of the composition is 12 wt.%, the total weight of the copper formate in relation to the total weight of the composition is 12 wt.% and the total weight of the amino-2-propanol in relation to the total weight of the composition is 12 wt.%. The total content of solids in each of the sintering pastes from compositions No. 8 to No. 13 is 68 wt.%.

In each of the sintering pastes from compositions No. 14 to No. 20, the total weight of the etched brass flakes in relation to the total weight of the composition is 60 wt.%, the total weight of the ethylene glycol in relation to the total weight of the composition is 13 wt.%, the total weight of the copper formate in relation to the total weight of the composition is 13 wt.% and the total weight of the amino-2-propanol in relation to the total weight of the composition is 13 wt.%. The total content of solids in each of the sintering pastes from compositions No. 14 to No. 20 is 64 wt.%.

### Example 2: Sintering paste production

In the following, the formulation of a sintering paste according to the invention is exemplarily shown. The formulation of the paste comprises the following steps:
Copper formate tetrahydrate is dried in air at 100 °C for 30 minutes and crushed manually. This procedure is repeated two times. By drying the copper formate, the water complexed with the copper formate molecules are removed and crushed anhydrous copper formate crystals can be obtained.

Equal amounts of mass of the dried and crushed copper formate and ethylene glycol are mixed resulting in a suspension of copper formate in ethylene glycol.

In order to dissolve copper formate, amino-2-propanol is added in a molar ratio of 1:2 compared to copper formate (which refers to 1:1 wt.%). The copper formate is complexed by the amino-2-propanol. Since amino-2-propanol has both a hydroxy group (-OH group) and an amine group (-NH₂ group), the Cu center of the copper formate is bound by amino-2-propanol through two sites. Therefore, amino-2-propanol serves as a bidentate ligand. The bidentate complexation of the copper formate by the amino-2-propanol results in a complexed copper formate which is able to be dissolved in the ethylene glycol resulting in a mixture of the components.

Subsequently, copper flakes or etched brass flakes are added to the mixture in a mass ratio of 50:50. The resulting mixture is then heated to 160 °C in a reflow oven under nitrogen atmosphere and allowed to stay for 30 minutes.

During the heating process, copper nanoparticles are formed by thermal decomposition of the copper formate amino-2-propanol complex. The binder ethylene glycol evaporates, but a sufficient quantity remains in order to ensure a paste like consistency, in particular at least 5 wt.%. Due to the remaining ethylene glycol, the obtained sintering paste confers a good printability and is easily cleanable from surfaces compared to traditional solder pastes.

### Example 3: Sinter process and sintering bond strength

The sintering pastes from example 1 are each stencil printed on a copper substrate (30 mm × 30 mm × 1.5 mm) using a PBT-Uniprint-PMGo3v semi-automatic stencil printer equipped with a motorized double blade squeegee and a stencil thickness of 75 µm. The sintering pastes from example 2 are sintered by a two-step sintering process. First, pre-drying of the stencil printed paste in a formic acid enriched nitrogen (N₂) atmosphere, in a nitrogen gas atmosphere or in air is performed depending on the respective sintering paste. The pre-drying is performed for 5 minutes to 15 minutes at 120 °C to 140 °C.

Here, exemplarily two sintering paste types are compared. In the first sintering paste type, which is not a sintering paste according to the invention, *in situ* formation of copper nanoparticles is performed during the pre-drying step. In the second sintering paste type according to the invention, the *in situ* formation of copper nanoparticles is performed prior the pre-drying step according to the heating process indicated in example 2. Therefore, the second sintering paste type already contains copper nanoparticles during the pre-drying step. The sintering pastes from compositions No. 8 to No. 11 and No. 14 to No. 19 of Table 1 belong to the first sintering paste type. The sintering pastes from compositions No. 12, No. 13 and No. 20 of Table 1 belong to the second sintering paste type.

After pre-drying of the sintering paste, Si or Si₃N₄ chips with a footprint of 2.5 mm² and 120 µm thickness with gold end metallization are applied on the stencil printed pre-dried sintering paste using a Fineplacer^{®} Sigma bonder with a specifically designed bonding chamber with a precision of ± 1 N of force.

After chip placement, sintering for 5 minutes to 30 minutes at a sintering temperature of 250 °C to 275 °C under the application of 10 MPa to 20 MPa bonding pressure in a specifically designed open bond chamber under a nitrogen flow of 3 L/min is performed, depending on the respective sintering paste. The specifically designed open bond chamber contains residual oxygen. However, oxidation of the copper is prevented by provision of a reducing atmosphere. The sintering pastes from compositions No. 1 to No. 5 are sintered at 275 °C in order to obtain a copper bond. Sintering temperature is reached at a heating rate of 5 K/s. An initial contact force of 5 N is applied followed by a ramp up to final bonding force at the rate of 5 N/s. A 75 µm thick polyimide foil is used between the tool tip and the samples to ensure uniform pressure distribution and to avoid any damage to the chip surfaces by direct contact with the metal tool tip.

After sintering, the sintering bond strength of the sintered copper bonding is measured by a shear test. The shear test is performed according to MIL-STD-883E test method standard for microcircuits using a XYZTec Condor Sigma Lite shear tester with a shear height of 25 µm and a shear speed of 200 µm/s.

The results are given in the following table:

**Table 2: Shear strength values and processing conditions of the sintered copper bondings**

| **SI.No** | **Sintering paste composition** | | | **Arithmetic average shear strength values (MPa)** | **Processing conditions** | | | | | | | |
|---|---|---|---|---|---|---|---|---|---|---|---|---|
| **-** | **Copper-containing microparticles** | **Binder** | **Copper formate and complexing aqent** | | ***In situ* nanoparticle formation** | **Pre-drying conditions** | | | **Sintering conditions** | | | |
| | | | | | | **Atmosphere** | **Time (min)** | **Temperature (°C)** | **Atmosphere** | **Time (min)** | **Temperature (°C)** | **Bonding Pressure (MPa)** |
| 1 | Copper flakes | Octanol | - | 24 ± 15 | - | formic acid enriched N2 (< 100 ppm O₂, < 5 wt.% formic acid) | 10 | 120 | formic acid enriched N2 in open bond chamber (< 100 ppm O₂, < 5 wt.% formic acid) | 5 | 250 | 20 |
| 2 | Copper flakes | Butanol | - | 28 ± 22 | - | formic acid enriched N2 (< 100 ppm O₂, < 5 wt.% formic acid) | 10 | 120 | formic acid enriched N2 in open bond chamber (< 100 ppm O₂, < 5 wt.% formic acid) | 5 | 250 | 20 |
| 3 | Copper flakes | Ethylene glycol | - | 27 ± 15 | - | N₂ | 5 | 120 | N2 in open bond chamber (> 100 ppm O₂) | 5 | 275 | 10 |
| 4 | Etched brass flakes | Ethylene glycol | - | 55 ± 6 | - | N₂ | 5 | 120 | N2 in open bond chamber (> 100 ppm O₂) | 5 | 275 | 10 |
| 5 | Etched brass flakes | Po-lyehty-lene glycol 600 | - | 57 ± 2 | - | air | 5 | 120 | N2 in open bond chamber (> 100 ppm O₂) | 30 | 275 | 10 |
| 6 | Etched brass flakaes | alpha-terpineol + PEG600 | - | 60 ± 6 | - | air | 5 | 120 | N2 in open bond chamber (> 100 ppm O₂) | 5 | 275 | 10 |
| 7 | Copper flakes | alpha-terpineol + PEG600 | - | 50 ± 7 | - | air | 5 | 120 | N2 in open bond chamber (> 100 ppm O₂) | 5 | 275 | 20 |
| 8 | Copper flakes | Ethylene glycol | Copper formate + Amino-2-propanol | 42 ± 19 | During the pre-drying step | formic acid enriched N2 (< 100 ppm O₂, < 5 wt.% formic acid) | 15 | 140 | formic acid enriched N2 in open bond chamber (< 100 ppm O₂, < 5 wt.% formic acid) | 5 | 250 | 20 |
| 9 | Copper flakes | Ethylene glycol | Copper formate + Amino-2-propanol | 49 ± 27 | During the pre-drying step | formic acid enriched N2 (< 100 ppm O₂, < 5 wt.% formic acid) | 15 | 140 | formic acid enriched N2 in open bond chamber (< 100 ppm O₂, < 5 wt.% formic acid) | 5 | 250 | 20 |
| 10 | Copper flakes | Ethylene glycol | Copper formate + Amino-2-propanol | 59 ± 27 | During the pre-drying step | formic acid enriched N2 (< 100 ppm O₂, < 5 wt.% formic acid) | 15 | 140 | formic acid enriched N2 in open bond chamber (< 100 ppm O₂, < 5 wt.% formic acid) | 5 | 250 | 20 |
| 11 | Copper flakes | Ethylene glycol | Copper formate + Amino-2-propanol | 73 (only one measurement. No std.dev. Available) | During the pre-drying step | formic acid enriched N2 (< 100ppm O₂, < 5 wt.% formic acid) | 15 | 140 | formic acid enriched N2 in open bond chamber (< 100 ppm O₂, < 5 wt.% formic acid) | 5 | 250 | 20 |
| 12 | Copper flakes | Ethylene glycol | Copper formate + Amino-2-propanol | 80 ± 6 | Prior to the pre-drying step | formic acid enriched N2 (< 100 ppm O₂, < 5 wt.% formic acid) | 15 | 140 | formic acid enriched N2 in open bond chamber (< 100 ppm 02, < 5 wt.% formic acid) | 5 | 250 | 20 |
| 13 | Copper flakes | Ethylene glycol | Copper formate + Amino-2-propanol | 92 ± 15 | Prior to the pre-drying step | formic acid enriched N2 (< 100 ppm O₂, < 5 wt.% formic acid) | 15 | 140 | formic acid enriched N2 in open bond chamber (< 100 ppm 02, < 5 wt.% formic acid) | 5 | 250 | 20 |
| 14 | Etched brass flakes | Ethylene glycol | Copper formate + Amino-2-propanol | 82 ± 28 | During the pre-drying step | formic acid enriched N2 (< 100 ppm O₂, < 5 wt.% formic acid) | 15 | 140 | formic acid enriched N2 in open bond chamber (< 100 ppm 02, < 5 wt.% formic acid) | 5 | 250 | 20 |
| 15 | Etched brass flakes | Ethylene glycol | Copper formate + Amino-2-propanol | 66 ± 9 | During the pre-drying step | formic acid enriched N2 (< 100 ppm O₂, < 5 wt.% formic acid) | 15 | 140 | formic acid enriched N2 in open bond chamber (< 100 ppm 02, < 5 wt.% formic acid) | 5 | 250 | 20 |
| 16 | Etched brass flakes | Ethylene glycol | Copper formate + Amino-2-propanol | 60 ± 9 | During the pre-drying step | formic acid enriched N2 (< 100 ppm O₂, < 5 wt.% formic acid) | 15 | 140 | formic acid enriched N2 in open bond chamber (< 100 ppm 02, < 5 wt.% formic acid) | 5 | 250 | 20 |
| 17 | Etched brass flakes | Ethylene glycol | Copper formate + Amino-2-propanol | 65 ± 33 | During the pre-drying step | formic acid enriched N2 (< 100 ppm O₂, < 5 wt.% formic acid) | 15 | 140 | formic acid enriched N2 in open bond chamber (< 100 ppm 02, < 5 wt.% formic acid) | 5 | 250 | 20 |
| 18 | Etched brass flakes | Ethylene glycol | Copper formate + Amino-2-propanol | 101 ± 25 | During the pre-drying step | formic acid enriched N2 (< 100 ppm O₂, < 5 wt.% formic acid) | 15 | 140 | formic acid enriched N2 in open bond chamber (< 100 ppm 02, < 5 wt.% formic acid) | 5 | 250 | 20 |
| 19 | Etched brass flakes | Ethylene glycol | Copper formate + Amino-2-propanol | 84 ± 28 | During the pre-drying step | formic acid enriched N2 (< 100 ppm O₂, < 5 wt.% formic acid) | 15 | 140 | formic acid enriched N2 in open bond chamber (< 100 ppm 02, < 5 wt.% formic acid) | 5 | 250 | 20 |
| 20 | Etched brass flakes | Ethylene glycol | Copper formate + Amino-2-propanol | 95 ± 12 | Prior to the pre-drying step | formic acid enriched N2 (< 100 ppm 02, < 5 wt.% formic acid) | 15 | 140 | formic acid enriched N2 in open bond chamber (< 100 ppm 02, < 5 wt.% formic acid) | 5 | 250 | 20 |

In Table 2, the sintering bond strength of the sintered copper bonding is given as mean of arithmetic average shear strength values ± SD (n = 25). As can be seen in Table 2, the sintering bond strength of the sintered copper bonding from compositions No. 1 to No. 7 show arithmetic average shear strength values in the range of 24 MPa to 60 MPa. The sintering bond strength of the sintered copper bonding from compositions No. 8 to No. 13 and No. 14 to No. 20 show arithmetic average shear strength values in the range of 42 MPa to 92 MPa and in the range of 60 MPa to 101 MPa, respectively.

Furthermore, the arithmetic average shear strength values of the sintered copper bonding from compositions No. 8 to No. 13 is highest for composition No. 12 and composition No. 13 showing arithmetic average shear strength values of 80 MPa and 92 MPa, respectively. In composition No. 12 and in composition No. 13, the *in situ* nanoparticle formation is performed prior to the pre-drying step.

The inventors found that 2-amino-2-methylpropan-1-ol as complexing agent also results in a copper bond with acceptable arithmetic average shear strength values, in particular if the *in situ* nanoparticle formation is performed prior to the pre-drying step.

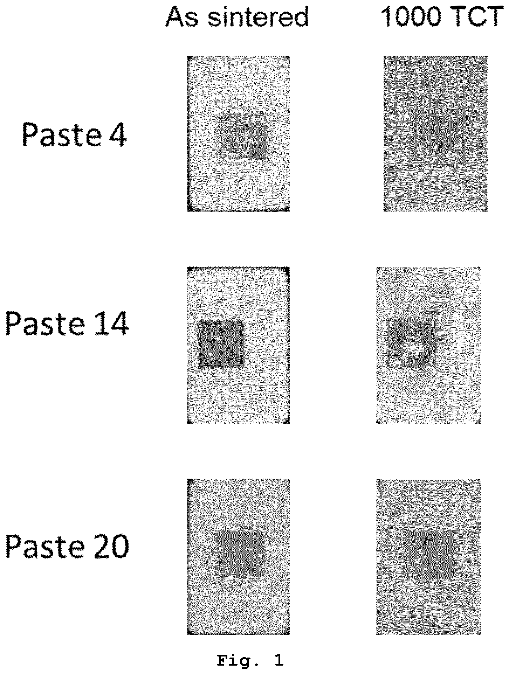

Furthermore, the surface structure of the sintered copper bonding from compositions No. 4, No. 14 and No. 20 are analyzed by acoustic microscopy analysis using a Nordson Sonoscan D9600 scanning acoustic microscope with a 100 MHz transducer. In composition No. 4, no *in situ* nanoparticle formation is performed due to the lack of copper formate and complexing agent. In composition No. 14, *in situ* nanoparticle formation is performed during the pre-drying step. In composition No. 20 - which is of identical composition as composition No. 14 - the *in situ* nanoparticle formation is performed prior to the pre-drying step. For these compositions, the surface structure of the sintered copper bonds is analyzed directly after sintering and after performing a temperature cycle test with 1000 cycles, wherein in each cycle the sintered copper bond is heated to a temperature of 140 °C and held at 140 °C for 30 minutes followed by cooling to a temperature of -55 °C and holding at -55 °C for 30 minutes. The results are given in Fig. 1.

On the left side of Fig. 1, the sintered copper bonding of compositions No. 4, No. 14 and No. 20 directly after sintering are shown, respectively. As can be seen in Fig. 1, the sintered copper bonding of composition No. 4 shows a relatively non-homogenous and irregular surface structure. Also the sintered copper bonding of composition No. 14 shows a relatively non-homogenous and irregular surface structure. In contrast to the sintered copper bonding of compositions No. 4 and No. 14, the sintered copper bonding of composition No. 20 shows a relatively homogenous and regular surface structure. Therefore, by *in situ* nanoparticle formation prior to pre-drying, an improved surface control of the sintered copper bonding is ensured.

On the right side of Fig. 1, the sintered copper bonding of compositions No. 4, No. 14 and No. 20 after performing the temperature cycle test are shown, respectively. As can be seen in Fig. 1, the non-homogeneity and the irregularity of the surface structure of the sintered copper bonding of compositions No. 4 and No. 14 are further increased after performing the temperature cycle test. In contrast to the sintered copper bonding of compositions No. 4 and No. 14, the sintered copper bonding of composition No. 20 maintains a relatively homogenous and regular surface structure. Therefore, by *in situ* nanoparticle formation prior to pre-drying, a relatively high resistance of exposure to alternating extremes of temperatures of the sintered copper bonding is ensured.

### Example 4: Surface structure

In a further example, the surface structure of a first sintering paste type and a second sintering paste type after pre-drying are analyzed by optical microscopy. As indicated above, in the first sintering paste type, *in situ* formation of copper nanoparticles is performed during the pre-drying step. In the second sintering paste type, the *in situ* formation of copper nanoparticles is performed prior the pre-drying step.

The exemplary first sintering paste of the first sintering paste type consists of 60 wt.% copper flakes, 13 wt.% Cu(II) formate, 13.5 wt.% ethylene glycol and 13.5 wt.% amino-2-propanol and was pre-dried at 140 °C for 15 minutes in a formic acid enriched nitrogen atmosphere. The first sintering paste has a total content of solids of 73 wt.%. For the second sintering paste type, a second sintering paste consisting of 50 wt.% copper flakes, 16.5 wt.% Cu(II) formate, 16.75 wt.% ethylene glycol and 16.75 wt.% amino-2-propanol was pre-dried at 140 °C for 15 minutes in a formic acid enriched nitrogen atmosphere. Prior to the pre-drying, *in situ* nanoparticle formation in the second sintering paste was performed according to the method indicated in example 2.

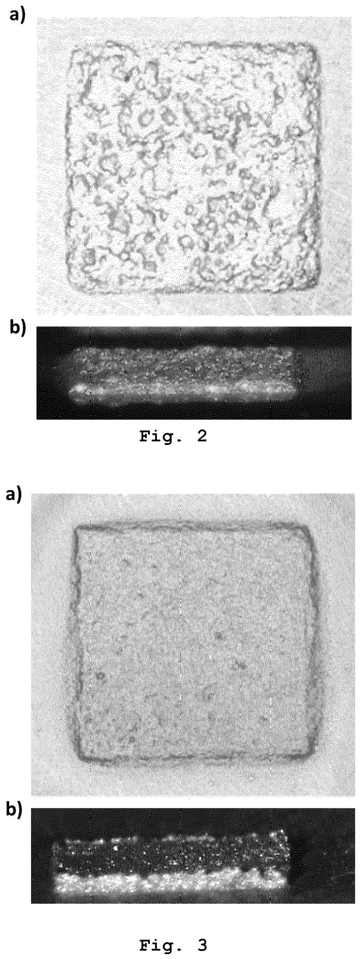

Optical microscopy imaging of the pre-dried sintering pastes is performed using a Keyence Digital microscope (top view). Side view imaging of the pre-dried sintering pastes is performed using the Fineplacer^{®} PICO. The results are given in Fig. 2 and Fig. 3. Fig. 2a shows the first sintering paste after pre-drying from top view, Fig. 2b shows the first sintering paste after pre-drying from side view. Fig. 3a shows the second sintering paste after pre-drying from top view, Fig. 3b shows the second sintering paste after pre-drying from side view.

As can be seen in Figs. 2a and 2b, the first sintering paste shows a relatively non-homogenous and irregular surface structure. This is due to volume shrinkage and degassing of organic components in the first sintering paste during the thermal decomposition of the complexed copper formate. A non-homogenous and irregular surface structure leads to insufficient bonding at the interface.

As can be seen in Figs. 3a and 3b, the second sintering paste shows a relatively homogenous and regular surface structure. The copper nanoparticles are already present in the second sintering paste during pre-drying. Furthermore, only a residual amount of the binder is present in the second sintering paste type in order to confer a paste-like consistency. Therefore, no volume shrinkage due to thermal decomposition or degassing of organic components occurs. The homogenous and regular surface structure leads to sufficient bonding at the interface. Therefore, by *in situ* formation of copper nanoparticles prior to pre-drying, an improved surface control of the sintering paste is ensured.

Furthermore, by application of a bonding force of 1000 N to the Si microchip placed on the pre-dried first or second sintering paste, the inventors found that the rough surface texture of the printed and pre-dried first sintering paste results in a non-uniform force distribution with a relatively high force variation of the bonding force applied to the microchip. A relatively high force variation of the applied bonding force on the microchip might result in the breaking of the microchip during placement and/or sintering of the microchip even if the microchip is placed by application of a relatively small placement force. In contrast to the first sintering paste, the uniform surface structure of the printed and pre-dried second sintering paste results in a uniform force distribution of the applied bonding force on the microchip, thus allowing the placement of a microchip onto the second sintering paste without breaking of the microchip.

### Example 5: Interconnect analysis

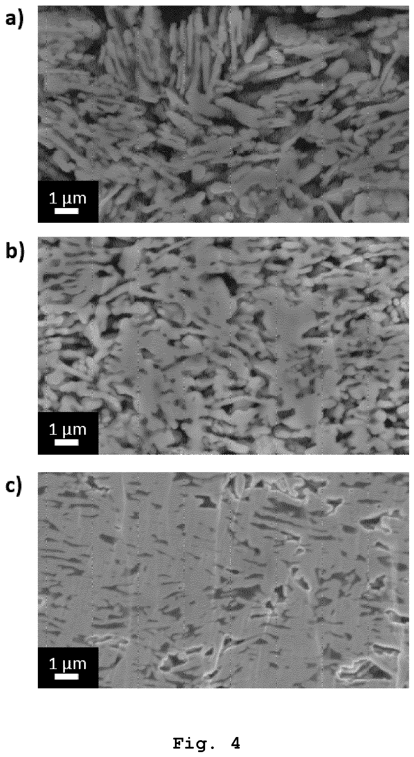

In addition, the sintered interconnect is analyzed by electron microscopy. For that, the first sintering paste, the second sintering paste and a control sintering paste are stencil printed on a copper substrate as indicated in example 3. The control sintering paste contains 65 wt.% copper flakes and 35 wt.% ethylene glycol, but no copper formate and no amino-2-propanol. After stencil printing, pre-drying of the stencil printed control sintering paste, the stencil printed first sintering paste and the stencil printed second sintering paste is performed at 140 °C for 5 minutes in a formic acid enriched nitrogen atmosphere followed by sintering at 250 °C for 5 minutes at a bonding pressure of 20 MPa in an open bond chamber under constant flow of formic acid enriched nitrogen. After sintering, cross sections of the control sintering paste interconnect, the first sintering paste interconnect and the second sintering paste interconnect are prepared using a JEOL SM-09010 Ar-lon beam miller. The cross sections of the control sintering paste interconnect, the first sintering paste interconnect and the second sintering paste interconnect are analyzed using a Zeiss EVO MA 1 scanning electron microscope (SEM). The results are given in Fig. 4. Fig. 4a shows the SEM image of the cross section of the control sintering paste interconnect. Fig. 4b shows the SEM image of the cross section of the first sintering paste interconnect. Fig. 4c shows the SEM image of the cross section of the second sintering paste interconnect.

As can be seen in Fig. 4a, Fig. 4b and Fig. 4c, the interconnect resulting from sintering of the second sintering paste is denser compared to the interconnects resulting from sintering of the control sintering paste and the first sintering paste, respectively. In contrast to the interconnect resulting from the second sintering paste, the interconnect resulting from the control sintering paste or the interconnect resulting from the first sintering paste shows relatively large voids. These relatively large voids are detrimental to the reliability of the sintered interconnect. This indicates that the *in situ* formation of nanoparticles prior to pre-drying results in a rapid and reliable sintering and efficient densification of the interconnect.

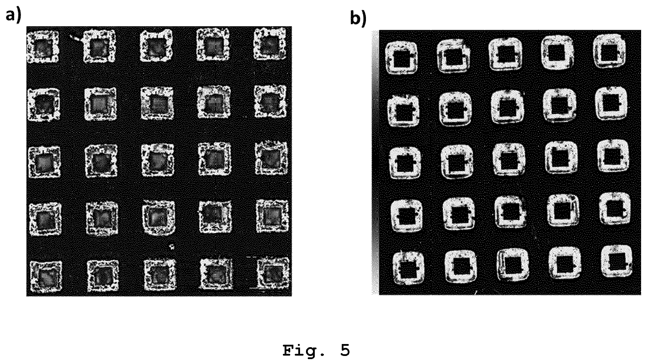

In another example, after Si chip placement and sintering, the interconnect between the Si chip and the substrate was analyzed by acoustic microscopy analysis using a Nordson Sonoscan D9600 scanning acoustic microscope with a 100 MHz transducer. The results are given in Fig. 5. Fig. 5a shows 25 individual interconnects formed by sintering of the first sintering paste. Fig. 5b shows 25 individual interconnects formed by sintering of the second sintering paste. The white frame-like structures refer to the sintered sintering paste stencil printed on the copper substrate but not covered by the Si chip. The square-like area within the white frame-like structures refers to the interconnect between the copper substrate and the Si chip. White spots within the interconnect refer to voids within the interconnect and thus to an interconnect having a relatively high porosity. Dark areas within the interconnect refer to densely sintered interconnects having a relatively low porosity.

As can be seen in Fig. 5a, the interconnect formed by sintering of the first sintering paste results in voids within the interconnect. Thus, *in situ* nanoparticle formation performed during the pre-drying step results in an interconnect with a relatively high porosity. As can be seen in Fig. 5b, the interconnect formed by sintering of the second sintering paste results in a densely sintered interconnect. Thus, *in situ* nanoparticle formation performed prior to the pre-drying step results in an interconnect having a relatively low porosity.

## Claims

1. A sintering paste for forming a copper-containing interconnection layer between two solid substrates, wherein the sintering paste is obtained by the following steps:
a) Providing copper-containing microparticles of elementary metal, a binder, a copper formate and a complexing agent complexing the copper formate, wherein the complexing agent is an alkanolamine or a diamine, wherein the binder is a diol or a triol,
b) mixing the copper formate, the binder and the complexing agent for obtaining a mixture,
c) mixing the mixture obtained in step b) and the copper-containing microparticles for obtaining a composition,
d) heating the composition obtained in step c) to a temperature in the range from 120 °C to 180 °C and maintaining the temperature,
e) waiting until at least 75 wt.% of the complexing agent is evaporated and copper nanoparticles are formed for obtaining the sintering paste.

2. Sintering paste according to claim 1, wherein the elementary metal forming the microparticles is copper or a copper alloy, in particular bronze or brass.

3. Sintering paste according to claims 1 or 2, wherein the microparticles are provided as flakes, in particular flakes having an arithmetic average particle diameter of at most 5 µm.

4. Sintering paste according to any of the preceding claims, wherein the microparticles have superficial recesses, in particular recesses formed by means of etching with an acid.

5. Sintering paste according to claim 4, wherein a maximal superficial extension of any of the recesses is 1 µm.

6. Sintering paste according to any of the preceding claims, wherein the copper formate is Cu(HCOO)₂, in particular anhydrous Cu(HCOO)₂.

7. Sintering paste according to any of the preceding claims, wherein the alkanolamine forming the complexing agent is an unbranched alkanolamine having a carbon chain length of at most six carbon atoms, in particular methanolamine, ethanolamine or amino-2-propanol, or 2-amino-2-methylpropan-1-ol, or wherein the diamine forming the complexing agent is ethylenediamine, 1,2-diaminopropane or 1,3-diaminopropane.

8. Sintering paste according to any of the preceding claims, wherein the diol forming the binder is a diol having an arithmetic average molar mass of at least 60 g/mol and most 100 g/mol, in particular ethylene glycol, diethylene glycol, propylene glycol or butylene glycol, and wherein the triol forming the binder is a triol having an arithmetic average molar mass of at least 75 g/mol and at most 100 g/mol, in particular glycerol.

9. Sintering paste according to any of the preceding claims, wherein the total weight of the microparticles is at most 50 wt.%, in particular at most 35 wt.%, of the total weight of the composition as specified in step c), wherein the total weight of the binder is at most 40 wt.%, in particular at most 25 wt.%, of the total weight of the composition as specified in step c), wherein the remaining part of the composition as specified in step c) is formed by the copper formate and the complexing agent.

10. A method for producing the sintering paste according to any of the preceding claims comprising the steps of
a) providing the copper-containing microparticles of elementary metal as specified in any of claims 1 to 5, the copper formate of claim 1 or the copper formate as specified in claim 6, the complexing agent as specified in claim 1 or 7 and the binder as specified in claim 1 or 8,
b) mixing the copper formate, the binder and the complexing agent for obtaining a mixture,
c) mixing the mixture obtained in step b) and the copper-containing microparticles for obtaining a composition,
d) heating the composition obtained in step c) to a temperature in the range from 120 °C to 180 °C and maintaining the temperature,
e) waiting until at least 75 wt.% of the complexing agent is evaporated and copper nanoparticles are formed for obtaining the sintering paste.

11. Method according to claim 10, wherein the temperature is a temperature in the range from 130 °C to 170 °C, in particular a temperature in the range from 140 °C to 160 °C, and/or wherein the temperature is maintained for at least 5 minutes, in particular at least 10 minutes, and for at most 30 minutes, in particular at most 25 minutes.

12. Method according to claim 10 or 11, wherein the method further comprises a step f) of cooling of the sintering paste obtained in step e) to a further temperature in the range from 15 °C to 40 °C.

13. Method according to any of claims 10 to 12, wherein at least steps d) and e) and optionally step f) are performed in a reducing atmosphere.

14. Method according to claim 13, wherein the reducing atmosphere is provided by means of a mixture of evaporated formic-acid and nitrogen gas or by means of a gas mixture of hydrogen and an inert gas, in particular a gas mixture of nitrogen and hydrogen or a gas mixture of argon and hydrogen.

15. Use of the sintering paste according to any of claims 1 to 9 for forming a copper-containing interconnection layer between two solid substrates, for die-attach bonding or for forming a conductive path on a solid substrate.
